(19)

Europäisches Patentamt

European Patent Office

Office européen des brevets

(11) **EP 4 506 697 A1**

(12) **EUROPEAN PATENT APPLICATION**

(43) Date of publication:
**12.02.2025  Bulletin 2025/07**

(21) Application number: **23190907.8**

(22) Date of filing: **10.08.2023**

(51) International Patent Classification (IPC):
***G01R 19/00*** (2006.01)      ***H02M 1/00*** (2006.01)

(52) Cooperative Patent Classification (CPC):
**G01R 19/0092; H02M 1/0009; H02M 7/5387;**
G01R 31/2644

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
 • **Airbus S.A.S.**
  **31700 Blangnac (FR)**
 • **Airbus Operations S.A.S.**
  **31060 Toulouse (FR)**

(72) Inventors:
 • **Kapaun, Florian**
  **31700 Blagnac (FR)**

 • **Steiner, Gerhard**
  **31700 Blagnac (FR)**
 • **Galla, Gowtham**
  **31700 Blagnac (FR)**
 • **Surapaneni, Ravi Kiran**
  **31700 Blagnac (FR)**
 • **Galek, Marek**
  **Toulouse 31060 (FR)**
 • **Klugbauer, Josef**
  **Toulouse 31060 (FR)**

(74) Representative: **KASTEL Patentanwälte PartG
mbB
St.-Cajetan-Straße 41
81669 München (DE)**

(54) **CURRENT MEASURING METHOD AND POWER MODULE**

(57)     The invention relates to the field of power electronics. In order to enable a high speed and accurate current measuring in a power module (14) without influencing the power module (14) itself, the invention provides a current measuring method for measuring current in an electrical power module (14) comprising measuring the current over a parasitic element (22, L1-L4) of the power module (14).

Fig. 2

**Description**

The invention relates to a current measuring method for measuring current in an electrical power module. Further, the invention relates to a power module configured to conduct such current measuring method. Further, the invention relates to an aircraft comprising such a power module.

The invention relates to the field of power electronics. State of the art measures to determine currents in electrical power systems is to use heavy and bulky external current sensors that benefit from different physical measurement principles. In most cases "only" the load current is measured, as this can be done easily with relatively low speed (some kHz). Unfortunately, these methods do not allow to determine the semiconductor currents itself during e.g., switching transitions.

An object of the invention is to provide a method for high speed and accurate current measuring in a power module without influencing the power module itself.

For achieving such object, the invention provides a current measuring method of claim 1. A power module configured for automatically conducting such method is given in the further independent claim.

Advantageous embodiments are subject-matters of the dependent claims.

The invention provides a current measuring method for measuring current in an electrical power module comprising measuring the current over a parasitic element of the power module.

Preferably, the parasitic element is a stray inductance.

Preferably, the current in a commutation loop of the semiconductor power module is measured over the stray inductance of the commutation loop.

Preferably, current is measured over different parasitic elements of the power module.

Preferably, the power module has a half bridge configuration, wherein the method comprises multiple measurements at different point to distinguish between current in high side and low side transistors in the half bridge configuration.

Preferably, a current is measured between a first and a second connection point of the power module with the steps:

a) determining a parasitic resistance parameter, especially a parasitic inductive resistance, of the power module between the first and second connection points,
b) measuring the actual voltage between the first and second connection points,
c) determining the actual current between the first and second connection points from the actual voltage and the parasitic resistance parameter.

Preferably, steps a) is conducted once before use of the power module.

Preferably, step a) is conducted once for the same type of power modules.

Preferably, the method comprises the steps:

e) determining a stray inductance L of a loop in the power module,
f) measuring a voltage u(t) over the stray inductance, and

$$i(t) = \frac{1}{L} \int u(t) dt$$

g) determining the current of the loop of the power module.

Preferably, steps e) is conducted once before use of the power module.

Preferably, step e) is conducted once for the same type of power modules.

Preferably, step g) is conducted with the help of a high-speed operational amplifier circuit.

Preferably, in step f) and g), a complete switching transition of the power module is traced.

Preferably, in step g), the current i(t) is digitalized.

Preferably, the method comprises determining the current between the load connection and at least one of the Kelvin-source of the power module.

According to another aspect, the invention provides a power module configured to conduct the current measuring method according to any of the aforementioned embodiments.

In some embodiments, the power module is a complete sub-system of a larger power supplying system. In some embodiments, the power module comprises several semiconductor power moduls or semiconductor power units, especially semiconductor dies with power switches.

Preferably, the power module has a voltage measurement device configured to measure voltage between connection points of the half-bridge configuration.

Preferably, the power module has a computing device configured to determine the current between the connection points from a known parasitic resistance parameter between the connection points and the measured voltage.

For example, the computing device includes a high-speed operational amplifier circuit.

Preferably, the power module has a half-bridge configuration.

The current measuring method and the power module according to preferred embodiments of the invention can be used in different electronic environments. For example, the power module is a power module for supplying a personal computer or any other computer. For example, the power module and the current measuring method are used on board of an aircraft.

According to another aspect, the invention provides an aircraft comprising a power module according to any of the aforementioned embodiments.

Preferred embodiments of the invention describe a method that realizes the current measurement in a non-standard manner, without the need of external sense equipment. In some embodiments, an additional circuit for current measurements only needs some analogue components and can easily be integrated to standard power modules or modified power circuits.

Despite standard measurement techniques, mainly the internal parasitics are used. Therefore, no additional weight and volume is generated.

In some embodiments, due to the direct measurement in the commutation loop, it becomes feasible to directly detect the transistor current at very high frequency (typically the nominal switching).

Alternatives aiming direct transistor-current measurement like e.g. current shunts have the huge drawback that the commutation loop and therefore the switching behavior is negatively influenced.

Preferred embodiments provide a PC current measurement via at least one stray inductance.

With preferred embodiments of the invention, weight and volume as well as costs are decreased.

The invention describes a method that uses the parasitic elements that are present in all electronic circuits.

In some embodiments, one very dominant part is the so-called stray inductance in the commutation loop that needs to be minimized but cannot be avoided. Fortunately, this element is not completely useless as it can be used to measure the current within the commutation loop.

In some embodiments, multiple measurements at different points even allow distinguishing between high side and low side transistors in a half bridge configuration.

Embodiments of the invention are explained below referring to the accompanying drawings in which:

Fig. 1　a schematic view of an aircraft with an electronic device and a power module for supplying the electronic circuit with electrical power;

Fig. 2　a block diagram of an embodiment of the power module.

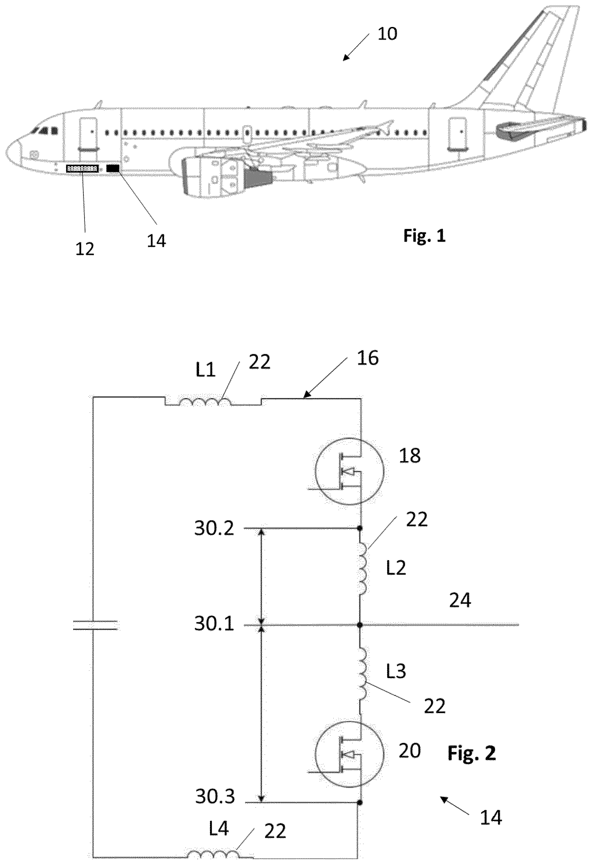

Fig. 1 shows an aircraft 10 with an electric or electronic device 12 and an electrical power module 14 for supplying the electric or electronic device 12 with electrical power. The electric or electronic device 12 can be any electric or electronic device to be used on the aircraft 10, such as a part of a flight computer, a flight controller, an electronic instrument, a computing device, a personal computer, a communication device, a transmitter, a receiver, or a part of a passenger entertainment system, an electric motor, an electric propulsion component or a high-power consumer, especially including an electric motor for propulsion.

The electrical power module 14 is a power electronics for supplying adequate electrical power to the electric or electronic device 12. The power module 14 transfers power from a DC or AC source (often mains power, e.g., AC adapter) to DC loads 24, such as a personal computer, or AC loads, such as an electric motor, while converting voltage and current characteristics. In some embodiments, the power module 14 can be (part of) a motor inverter.

The power module 14 has power semiconductors for high current throughput. In some embodiments, the power module 14 is a switched-mode power supply (SMPS). A switched-mode power supply is an electronic power supply that incorporates a switching regulator to convert electrical power efficiently. In some embodiments, the power module 14 has a half-bridge configuration.

Fig. 2 shows a circuit diagram of an embodiment of the power module 14 with a half-bridge configuration wherein a commutation loop 16 with a high-side transistor 18 and a low side transistor 20 is shown. Further, components of the power module 14 such as a computing component or controlling element are omitted for illustrative purposes.

Further, parasitic elements 22 of the power module 14 are shown in Fig. 2. In electrical networks, a parasitic element is a circuit element (resistance, inductance or capacitance) that is possessed by an electrical component but which it is not desirable for it to have for its intended purpose. For instance, a resistor is designed to possess resistance, but will also possess unwanted parasitic inductance.

Parasitic elements are unavoidable. All conductors possess resistance and inductance. Component designers will strive to minimise parasitic elements but are unable to eliminate them. Discrete components will often have some parasitic values detailed on their datasheets to aid circuit designers in compensating for unwanted effects.

In the following, a new method for high speed and accurate current measuring without influencing the power module 14 itself is described. Despite standard measurement techniques, mainly the internal parasitic elements 14 are used for a direct current measurement in the commutation loop 16.

Fig. 2 shows a half-bridge configuration with typical parasitic elements 22, especially parasitic inductances L1-L4.

Due to the electrical behaviour of inductors, each change in current (di/dt) results in an induced voltage:

$$(1)\qquad u(t) = L * di/dt.$$

If this equation is solved for the desired current i, simply the integral over the induced voltage must be determined:

$$(2) \qquad i(t) = \frac{1}{L} \int u(t)dt$$

The integral can be determined with the help of a fast operational amplifier (integrator) circuit and in a second step be digitized (if required). If the complete switching transition is traced, the integral value directly reflects the actual current.

The commutation loop 16 is not influenced in contrast to a shunt measurement.

In most state-of-the-art power modules, a first to third connection point 30.1-30.3 as shown in Fig. 2 are easily accessible wherein the first connection point 30.1 is the load connection, and the second and third connection points 30.2, 30.3 are Kelvin-source connections of the power module 14 or of the die carrying it (a die, in the context of integrated circuits, is a small block of semiconducting material on which a given functional circuit is fabricated).

In the example of Fig. 2, a current i2 between the second connection point 30.2 and first connection point 30.1 is measured over the second parasitic inductance L2 for determining the current through the high-side transistor 18, and further, a current i3 between the third connection point 30.3 and the first connection point 30.1 is measured over the third parasitic inductance L3 for determining the current through the low-side transistor 20. The currents i2 and i3 are determined as mentioned above with equitation (2) with L2 or L3, respectively as L, using a high-speed operational amplifier circuit (not shown, available on market).

The values for L2 and L3 have to be predetermined once at the beginning. As same modules do not vary a lot for these parameters calibration does not have to be done for all devices of the same unit.

The current measurement as described provides at least one, several or all of the following advantages:

- no additional parts in the power circuit are necessary
- very fast and accurate measurement
- measurement of the real transistor current not the load current
- can be used for critical protection functionality of the module
- high signal level due to high di/dt of wide bandgap semiconductors
- almost no additional costs

The invention relates to the field of power electronics. In order to enable a high speed and accurate current measuring in a power module (14) without influencing the power module (14) itself, the invention provides a current measuring method for measuring current in an electrical power module (14) comprising measuring the current over a parasitic element (22, L1-L4) of the power module (14).

Reference sign list:

| 10 | aircraft |
|----|----------|
| 12 | electronic device |
| 14 | power module |
| 16 | commutation loop |
| 18 | high-side transistor |
| 20 | low-side transistor |
| 22 | parasitic element |
| 24 | load |
| 30.1 | first connection point, load connection |
| 30.2 | second connection point, Kelvin-source connection |
| 30.3 | third connection point, Kelvin-source connection |
| L1 | first parasitic inductance (example for parasitic element, stray inductance) |
| L2 | second parasitic inductance (example for parasitic element, stray inductance) |
| L3 | third parasitic inductance (example for parasitic element, stray inductance) |
| L4 | fourth parasitic inductance (example for parasitic element, stray inductance) |

**Claims**

**1.** Current measuring method for measuring current in an electrical power module (14) comprising measuring the current over a parasitic element (22, L1-L4) of the power module (14).

**2.** Current measuring method according to claim 1, **characterized in that** the parasitic element (22) is a stray inductance (L1-L4).

**3.** Current measuring method according to claim 2, **characterized in that** the current in a commutation loop (16) of the power module (14) is measured over the stray inductance (L1-L4) of the commutation loop (16).

**4.** Current measuring method according to any of the preceding claims, **characterized in that** current is measured over different parasitic elements (22, L2, L3) of the power module (14).

**5.** Current measuring method according to claim 3 and claim 4, **characterized in that** the power module (14) has a half bridge configuration, wherein the method comprises multiple measurements at different points to distinguish between current in high side and low side transistors (18, 20) in the half bridge configuration.

**6.** Current measuring method according to any of the preceding claims, **characterized in that** a current is measured between a first and a second connection point (30.1, 30.2; 30.1, 30.3) of the power module (14) with the steps:

a) determining a parasitic element (22), especially a parasitic inductance (L2), of the power module (14) between the first and second connection points (30.1, 30.2),
b) measuring the actual voltage between the first and second connection points (30.1, 30.2),
c) determining the actual current between the first and second connection points (30.1, 30.2) from the actual voltage and the parasitic element (22, L2).

**7.** Current measuring method according to any of the preceding claims, **characterized by** the step:

e) determining a stray inductance (L1-L4) of a loop (16) in the power module (14),
f) measuring a voltage u(t) over the stray inductance (L1-L4), and
g) determining the current

$$i(t) = \frac{1}{L} \int u(t)dt$$

of the loop (16) of the power module (14).

**8.** Current measuring method according to claim 6, **characterized in that**

8.1 step g) is conducted with the help of a high-speed operational amplifier circuit and/or
8.2 in step f) and g), a complete switching transition is traced and/or
8.3 in step g), current i(t) is digitalized.

**9.** Current measuring method according to any of the claims 7 or 8, **characterized in that** steps a) or e)

9.1 are conducted once before use of the power module (14) and/or
9.2 are conducted once for the same type of power modules (14).

**10.** Current measuring method according to any of the preceding claims, **characterized in** determining the current between the load connection (30.1) and at least one of the Kelvin-sources (30.2, 303) of the power module (14) or of a die carrying it.

**12.** Power module (14) configured to conduct the current measuring method according to any of the preceding claims.

**13.** Power module (14) according to claim 12, having a voltage measurement device configured to measure voltage between connection points (30.1-30.3) of the half-bridge configuration and a computing device configured to determine the current between the connection points (30.1-30.3) from a known parasitic element parameter (22) between the connection points (30.1-30.3) and the measured voltage.

**14.** Power module (14) according to any of the claims 12 or 13, **characterized by** a half-bridge configuration.

**15.** Aircraft (10) comprising a power module (14) according to any of the claims 12 to 14.

Fig. 1

Fig. 2

## EUROPEAN SEARCH REPORT

Application Number

EP 23 19 0907

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CAIRNIE MARK ET AL: "Gate Driver for 10 kV SiC MOSFET Power Module with High-Speed Current Sensing", 2021 IEEE ENERGY CONVERSION CONGRESS AND EXPOSITION (ECCE), IEEE, 10 October 2021 (2021-10-10), pages 5385-5392, XP034020086, DOI: 10.1109/ECCE47101.2021.9595981 [retrieved on 2021-10-29] * page 5385, left-hand column, paragraph 1 - page 5391, right-hand column, paragraph 2 * | 1-14 | INV.<br>G01R19/00<br>H02M1/00 |
| X | SUN KEYAO ET AL: "Design, Analysis, and Discussion of Short Circuit and Overload Gate-Driver Dual-Protection Scheme for 1.2-kV, 400-A SiC MOSFET Modules", IEEE TRANSACTIONS ON POWER ELECTRONICS, INSTITUTE OF ELECTRICAL AND ELECTRONICS ENGINEERS, USA, vol. 35, no. 3, 1 March 2020 (2020-03-01), pages 3054-3068, XP011761791, ISSN: 0885-8993, DOI: 10.1109/TPEL.2019.2930048 [retrieved on 2019-12-19] * figures 1-26 * * page 3056, left-hand column, paragraph 2 - paragraph 3 * | 1,11 | |

| | |
|---|---|
| | TECHNICAL FIELDS SEARCHED (IPC) |
| | G01R<br>H02M |

The present search report has been drawn up for all claims

| Place of search | Date of completion of the search | Examiner |
|---|---|---|
| Munich | 21 December 2023 | Sedlmaier, Stefan |

EPO FORM 1503 03.82 (P04C01)